# EUROPEAN PATENT APPLICATION

(11) **EP 4 661 626 A1**
(43) Date of publication of application: **10.12.2025**
(21) Application number: 25156921.6
(22) Date of filing: 10.02.2025
(51) Int. Cl.: H10D 89/10, G06F 30/392, H10D 84/85, H10D 84/01

(54) **INTEGRATED CIRCUIT**

(30) Priority: 03.06.2024 KR 20240072549
(71) Applicant: Samsung Electronics Co., Ltd., Suwon-si, Gyeonggi-do 16677 (KR)
(72) Inventor: SONG, Junhyeok, Suwon-si (KR); LEE, Junhuck, Suwon-si (KR); CHOI, Yunho, Suwon-si (KR); HAN, Seongbeom, Suwon-si (KR)
(74) Representative: Marks & Clerk LLP

(57) **Abstract**

An integrated circuit (IC) includes a plurality of first tap cells arranged in a first column, and a plurality of second tap cells arranged in a second column and disposed in a row different from a row in which the plurality of first tap cells are disposed. The second column is adjacent to the first column in a first direction and spaced apart from the first column by a first distance. The IC includes a plurality of third tap cells arranged in a third column and disposed in a row different from the row in which the plurality of first tap cells are disposed and different from the row in which the plurality of second tap cells are disposed. The third column is adjacent to the first column in the first direction and spaced apart from the first column by a second distance that is different from the first distance.

## Description

### TECHNICAL FIELD

Embodiments of the present disclosure relate to the design and layout of integrated circuits (ICs).

### DISCUSSION OF RELATED ART

A floorplan is a key step in designing the layout of an integrated circuit. In the floorplan stage, space is allocated for macros that are to be placed next to each other, along with physical cells such as tap cells, endcap cells, and switch cells. The positions of these macros and cells, as determined by the floorplan, can significantly influence subsequent operations in the electronic design automation (EDA) process.

### SUMMARY

Embodiments of the present disclosure provide an integrated circuit (IC) in which a multi-row cell is efficiently disposed due to a change in a tap cell placement structure.

Embodiments of the present disclosure provide an integrated circuit (IC) having improved routing congestion.

According to an embodiment, an integrated circuit (IC) includes a plurality of first tap cells arranged in a first column, and a plurality of second tap cells arranged in a second column and disposed in a row that is different from a row in which the plurality of first tap cells are disposed. The second column is adjacent to the first column in a first direction and spaced apart from the first column by a first distance. The IC further includes a plurality of third tap cells arranged in a third column and disposed in a row different from the row in which the plurality of first tap cells are disposed and different from the row in which the plurality of second tap cells are disposed. The third column is adjacent to the first column in the first direction and spaced apart from the first column by a second distance that is different from the first distance.

According to an embodiment, an integrated circuit (IC) includes a first line extending in a first direction and configured to provide a power supply voltage, a second line extending in the first direction and configured to provide the power supply voltage, a third line extending in the first direction between the first line and the second line and configured to provide a ground voltage, a first switch cell overlapping the first line, the second line, and the third line, and spanning the first line and the second line, a first tap cell in contact with the first switch cell in the first direction, and spanning the first line and the third line, and a second tap cell spaced apart from the first tap cell by a first distance in a second direction perpendicular to the first direction, and spanning the second line.

According to an embodiment, an integrated circuit (IC) includes a first switch cell disposed in a first column among the first column, a second column, a third column, and a fourth column sequentially arranged and adjacent to one another in a first direction, a first tap cell disposed in the second column and in contact with the first switch cell in the first direction, a second tap cell disposed in the third column spaced apart by a first distance from the second column, and a second switch cell disposed in the fourth column and in contact with the second tap cell in the first direction.

At least some of the above and other features of the invention are set out in the claims.

### BRIEF DESCRIPTION OF THE DRAWINGS

The above and other features of the present disclosure will become more apparent by describing in detail embodiments thereof with reference to the accompanying drawings.
FIG. 1 is a flowchart showing an integrated circuit (IC) design and manufacturing method according to example embodiments.
FIG. 2 is a view schematically showing a design system of the IC.
FIG. 3 is a layout diagram showing a floorplan of a switch cell and a tap cell according to an embodiment.
FIG. 4 is a view for explaining a switch cell according to an embodiment.
FIG. 5 is a plan view of an IC according to an embodiment.
FIG. 6 is a cross-sectional view of an IC.
FIG. 7 is a layout plan view of the IC in FIG. 6.
FIG. 8 is a layout plan view of the tap cell and a complementary metal-oxide-semiconductor (CMOS) transistor according to an embodiment.
FIG. 9 is a plan view of an integrated circuit (IC) according to a comparative example.
FIG. 10 is a layout diagram showing a floorplan of a switch cell and a tap cell according to the comparative example.
FIG. 11 is a plan view of an IC according to an embodiment.
FIG. 12 is a plan view of an IC according to an embodiment.
FIG. 13 is a plan view of an IC according to an embodiment.
FIG. 14 is a plan view of an IC according to an embodiment.
FIG. 15 is a cross-sectional view schematically showing a semiconductor package including a semiconductor device based on an IC provided according to an embodiment.

### DETAILED DESCRIPTION OF THE EMBODIMENTS

Embodiments of the present disclosure will be described more fully hereinafter with reference to the accompanying drawings. Like reference numerals may refer to like elements throughout the accompanying drawings.

It should be understood that the embodiments described herein are intended to implement various features of the present disclosure. These embodiments are merely examples of the present disclosure, and are not intended to limit the present disclosure. For example, a dimension of the component is not limited to a published range or value, and may be changed based on a process condition and/or a desired device property. In addition, the following description may include embodiments where a first structure is formed on or above a second structure through direct contact between the first and second structures, and also include embodiments where an additional structure may be formed between the first and second structures to prevent the direct contact between the first and second structures.

Spatially relative terms, such as "beneath", "below", "lower", "under", "above", "upper", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below.

In addition, in the drawings, portions unrelated to the description may be omitted to clearly describe the present disclosure, and similar portions are denoted by similar reference numerals throughout the specification. In a flowchart described with reference to the drawings, an order of operations may be changed, several operations may be merged with each other, a certain operation may be divided, and a certain operation may not be performed.

It will be understood that when a component is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. Other words used to describe the relationships between components should be interpreted in a like fashion.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art. Further, it is to be understood that while parameters may be described herein as having "about" a certain value, according to embodiments, the parameter may be exactly the certain value or approximately the certain value within a measurement error as would be understood by a person having ordinary skill in the art. Other uses of these terms and similar terms to describe the relationships between components should be interpreted in a like fashion.

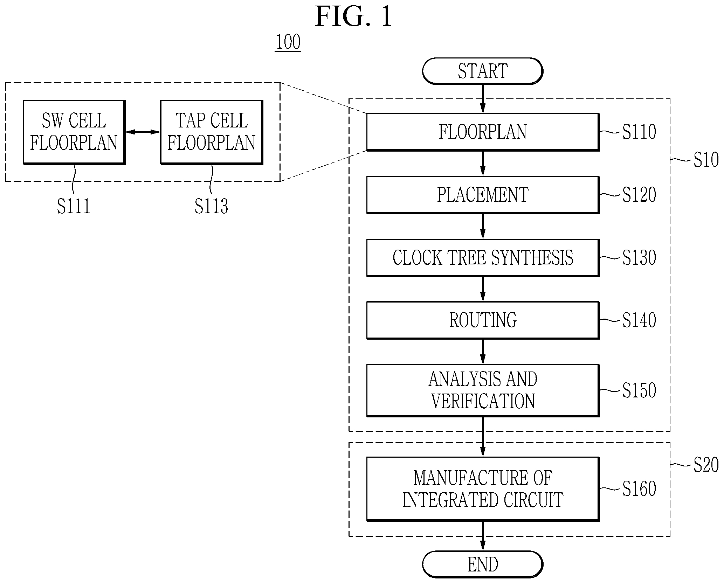

FIG. 1 is a flowchart showing an integrated circuit (IC) design and manufacturing method according to example embodiments.

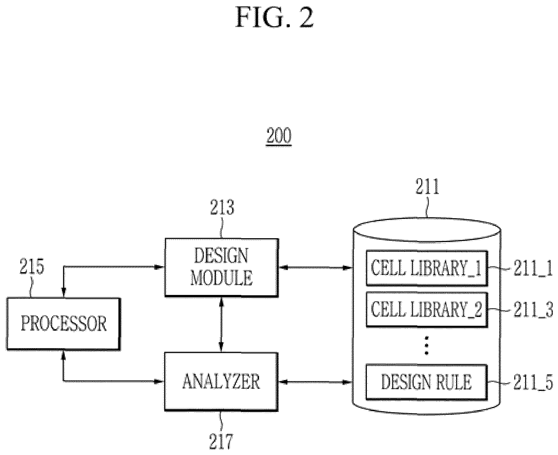

Referring to FIG. 1, an integrated circuit (IC) design and manufacturing method 100 may include an IC design operation (S10) and an IC manufacturing process operation (S20). The IC design operation (S10) is an operation of designing a layout of the circuit, and may be performed by a design module that performs design and verification of the IC. The design module that performs the IC design operation (S10) and a design system including the design module are described in more detail with reference to FIG. 2. The IC manufacturing process operation (S20) is an operation of manufacturing the IC based on the layout designed by the design system, and may be performed in a process module of the IC.

The IC design operation (S10) may include a floorplan operation (S1 10), a placement operation (S120), a clock tree synthesis (CTS) operation (S130), a routing operation (S140), and an analysis and verification operation (S150).

The floorplan operation (S110) may be an operation of physically designing a logically-designed schematic circuit by cutting and moving the circuit. In the floorplan, a space may be allocated for macros that are required to be disposed adjacent to each other in the layout design of the IC. In addition, the floorplan operation (S110) may include a switch cell (SW CELL) floorplan operation (5111) and a tap cell floorplan operation (S113).

In an embodiment, the switch cell floorplan operation (5111) may refer to an operation of floorplanning a switch cell in the IC. The switch cell may receive a power supply voltage (voltage drain to drain, VDD) from an external source, and output a virtual power supply voltage (VVDD) applied to a standard cell or the like that forms a logic circuit performing a predetermined logic operation. The switch cell may overlap a plurality of lines extending in a first direction in the IC. This line may be a metal line, but is not limited thereto. The maximum spacing at which the plurality of switch cells are repeatedly disposed in the IC in the first direction (e.g., X direction) may be predetermined. The design module and the design system including the same may dispose the switch cells based on the predetermined spacing at which the switch cells are required to be repeatedly disposed.

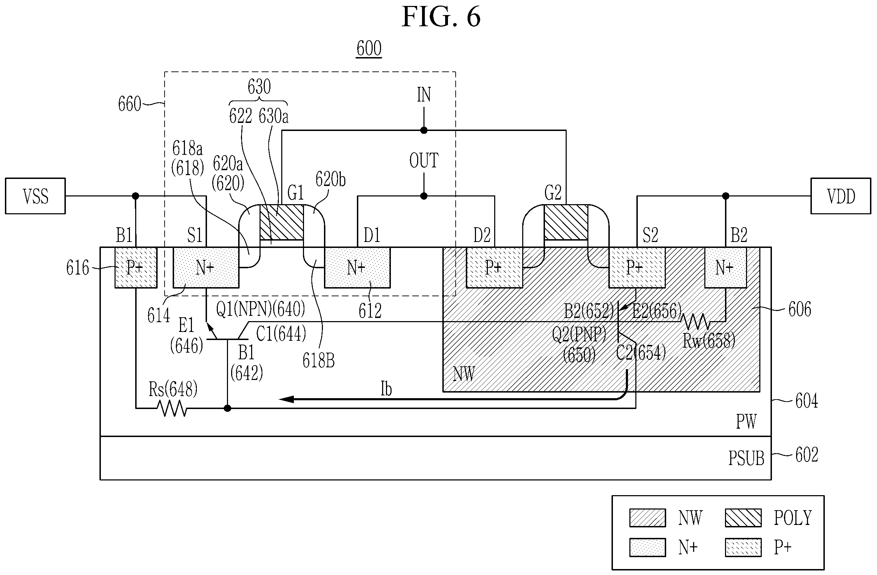

In an embodiment, the tap cell floorplan operation (S 1 13) may refer to an operation of floorplanning a tap cell in the IC. The tap cell may prevent a latch-up phenomenon that may be caused by a parasitic bipolar junction transistor (BJT) formed in the IC. The N well and P well of the standard cells, such as logic cells and the switch cell in the IC, may be tapped to a power supply voltage (VDD) line or a ground voltage (VSS) line through the tap cells. This configuration is described in detail with reference to FIGS. 6 to 8. The maximum spacing at which the tap cells in the IC are required to be repeatedly disposed in the first direction X may be predetermined. The design module and the design system including the same may dispose the tap cells based on the predetermined spacing at which the tap cells are required to be repeatedly disposed.

In an embodiment, the tap cells may be arranged in a plurality of columns arranged in the first direction (X). For example, a plurality of first tap cells arranged in a first column among the plurality of columns, may be adjacent to a plurality of second tap cells arranged in a second column in the first direction (X), and adjacent to a plurality of third tap cells arranged in a third column in the first direction (X). A distance in the first direction (X) between the plurality of first tap cells and the plurality of second tap cells may be different from a distance in the first direction (X) between the plurality of first tap cells and the plurality of third tap cells.

In an embodiment, each column may include the plurality of tap cells. For example, in the first column, the first tap cell, the second tap cell, and the third tap cell may be sequentially arranged in a second direction (e.g., Y direction) perpendicular to the first direction (X). In the first column, the first tap cell, the second tap cell, and the third tap cell may be sequentially arranged in the second direction (Y). In an embodiment, a distance in the second direction (Y) between the first tap cell and the second tap cell may be different from a distance in the second direction (Y) between the second tap cell and the third tap cell.

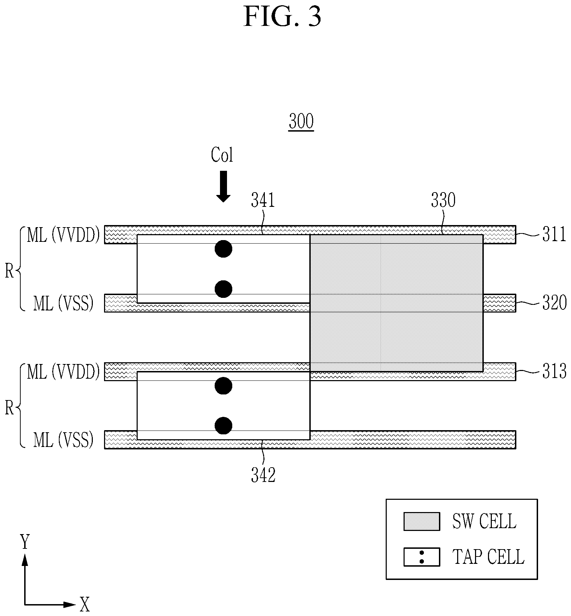

In an embodiment, the tap cell floorplan operation (S113) may be performed after performing the switch cell floorplan operation (S111). The tap cells may be disposed at the predetermined spacing based on the position of the switch cell. A placement form of the switch cell and the tap cell according to an embodiment is described in detail with reference to FIG. 3. However, the present disclosure is not limited thereto. For example, in embodiments, the switch cell floorplan operation (S111) may be performed after performing the tap cell floorplan operation (S113), or both of the operations may be performed simultaneously.

The placement operation (S120) may include an operation of disposing the logic cells. In the placement operation (S120), the logic cells may be disposed by considering an interface between the components in the IC. In the placement operation (S120), the logic cells may overlap the plurality of metal lines extending in the first direction in the IC. According to embodiments, in the placement operation (S120), the logic cells do not overlap the switch cells or the tap cells.

The CTS operation (S130) may be an operation of generating a clock distribution network to distribute clock signals to a set of sequential circuit elements of the IC.

The routing operation (S140) may be an operation of generating a routing structure including a plurality of wiring lines and a plurality of vias connecting the disposed logic cells to each other. In the routing operation (S140), pins of the logic cells may be routed. For example, the design module may generate interconnections that electrically connect the output pins and input pins of disposed logic cells. The routing structures may be formed on a plurality of layers.

The analysis and verification operation (S150) may be an operation of verifying and modifying the generated layout. Verification operations may include, for example, static timing analysis (STA), which verifies whether the layout satisfies a design timing condition, design rule check (DRC), which verifies whether the layout complies with a design rule, electronic rule check (ERC), which verifies whether an internal electrical connection is properly performed without interruption, and layout vs schematic (LVS), which verifies whether the layout matches a gate-level netlist.

The IC manufacturing process operation (S20) may include an IC manufacturing operation (S160).

The IC manufacturing operation (S160) may include a plurality of operations of manufacturing a mask and forming a semiconductor package. The IC manufacturing operation (S160) may include an operation of generating mask data for forming various patterns on the plurality of layers by performing optical proximity correction (OPC) or the like on the generated layout data in the IC design operation (S10) and an operation of manufacturing the mask by using the mask data. In the IC manufacturing operation (S160), various exposure and etching processes may be performed repeatedly. Through these processes, shapes of the patterns generated during the layout design may be sequentially formed on a silicon substrate.

In addition, in the IC manufacturing operation (S160), a packaging process of mounting the IC on a printed circuit board (PCB) and molding the same by using a molding material may be performed. Through the packaging process, the IC may be flipped or bonded onto the substrate by using a plurality of contact members.

FIG. 2 is a view schematically showing the design system of the IC.

A design system 200 may include a storage device 211, a design module 213, a processor 215, and an analysis module 217. The design system 200 in FIG. 2 may at least partially perform the design operation of the IC that is described in the IC design operation (S10) in FIG. 1. The design system 200 may be implemented as an integrated device, and may thus be referred to as a design device. The design system 200 may be provided as a dedicated device used to design the IC, and may also be a computer that drives various simulation tools or design tools.

In an embodiment, the storage device 211 may include, for example, first and second cell libraries 211_1 and 211_3, and may further include one or more design rules 211_5. The first and second cell libraries 211_1 and 211_3 and the design rule 211_5 may be provided from the storage device 211 to the design module 213 and the analysis module 217.

In an embodiment, the first and second cell libraries 211_1 and 211_3 may include various information about the standard cells. Here, the standard cells may include the logic cell, such as a logic element or a memory element, and the switch cell. The first and second cell libraries 211_1 and 211_3 may further include various information about a physical cell such as the tap cell or a filler cell. The standard cell may be implemented by, for example, at least one transistor, metal oxide semiconductor field effect transistor (MOSFET), fin field effect transistor (FinFET), or the like. However, the present disclosure is not limited thereto. The first and second cell libraries 211_1 and 211_3 may include layout information of the standard cell and the physical cell such as, for example, its height and size information and timing information of the standard cell, or the like. For example, some of the standard cells may have a first height, and the others of the standard cells may have a height greater than the first height. The minimum unit representing the cell height may be a distance between the metal lines extending in the first direction, adjacent to each other in the second direction perpendicular to the first direction, and applying the power supply voltage (VDD) and the ground voltage (VSS) to the standard cells.

In an embodiment, the design module 213 may receive the cell libraries 211_1 and 211_3 from the storage device 211 and use these libraries to perform the floorplan operation (S110) of floorplanning the switch cell, the tap cell, or the like in FIG. 1. In addition, the design module 213 may receive the cell libraries 211_1 and 211_3 from the storage device 211 and use the libraries to perform the placement operation (S120) of disposing the logic cells in FIG. 1. The number of cell libraries included in the storage device 211 may be changed in various ways.

In accordance with a trend of higher integration of IC devices, the design rules that are required to be considered during a design process may become diverse. The design rule 211_5 may be stored in the storage device 211. For example, the design rule 211_5 may include the distance at which the switch cells are required to be repeatedly disposed in the first direction (X), the distance at which the tap cells are required to be repeatedly disposed in the first direction (X), or the like, but is not limited thereto.

The design module 213 may perform the routing operation (S140) of connecting the disposed logic cells, the macros, and the like. In the routing operation (S140), the pins of the logic cells may be routed. In addition, the design module 213 may further include a configuration that performs the CTS operation (S140) in FIG. 1, or the like.

The term "module" may hereinafter refer to, for example, software, hardware such as a field programmable gate array (FPGA) or application specific integrated circuit (ASIC), or a combination of software and hardware.

The processor 215 may be used by the design module 213 and the analysis module 217 to perform operations. For example, the processor 215 may include a micro-processor, an application processor (AP), a digital signal processor (DSP), a graphic processing unit (GPU), or the like. FIG. 2 shows only one processor 215. However, the present disclosure is not limited thereto. For example, the design system 200 may also include a plurality of processors in some embodiments. The processor 215 may include a cache memory to improve computing performance.

The analysis module 217 may perform the analysis and verification operation (S150) in FIG. 1, and analyze and verify the floorplan, placement, and routing results. The analysis module 217 may analyze and verify whether the IC complies with the design rule 211_5, based on the design rule 211_5 received from the storage device 211.

FIG. 3 is a layout diagram showing the floorplan of the switch cell and the tap cell according to an embodiment. For example, FIG. 3 shows a portion of an IC 300 in which the switch cell floorplan operation (S111) and the tap cell floorplan operation (S113) are performed according to an embodiment.

In an embodiment, the IC 300 may include a plurality of lines ML extending in the first direction (X). Hereinafter, this line is described as the metal line, but the present disclosure is not limited thereto. The plurality of metal lines ML may intersect each other to provide the virtual power supply voltage (VVDD) and the ground voltage (VSS). Hereinafter, a row R may refer to a region extending in the first direction (X) between a plurality of metal lines 311 and 320 or 320 and 313 extending in the first direction (X) and adjacent to each other in the second direction (Y) perpendicular to the first direction (X).

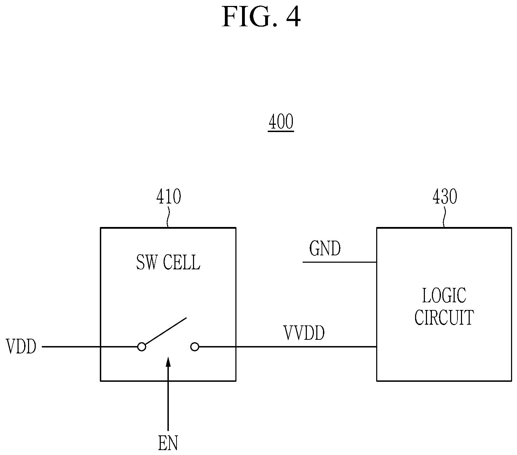

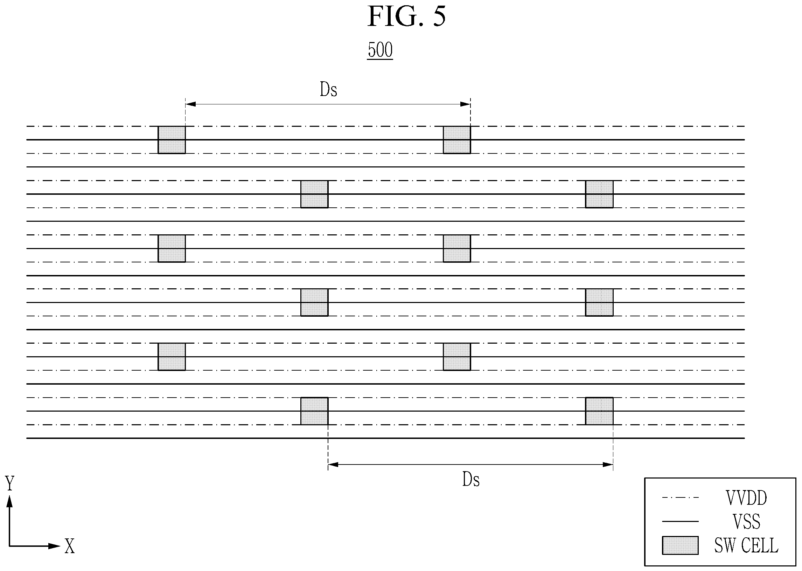

In an embodiment, a switch cell (SW CELL) 330 may overlap the plurality of metal lines ML. For example, the switch cell 330 may overlap at least one of the plurality of metal lines ML on an X-Y plane. For example, the switch cell 330 may overlap at least a portion of each of the first and second metal lines 311 and 313 that provide the virtual power supply voltage (VVDD) and the third metal line 320 that provides the ground voltage (VSS). The switch cell 330 may span the first metal line 311 and the second metal line 313 that provide the virtual power supply voltage (VVDD). For example, the switch cell 330 may overlap a portion of each of the first metal line 311 and the second metal line 313 in the second direction (Y). The switch cell 330 may provide the virtual power supply voltage (VVDD) to the logic cell, or the like, through the first and second metal lines 311 and 313. A height of the switch cell 330 may be the same as the two rows R. This switch cell may be referred to as a multi-row cell. However, the present disclosure is not limited thereto, and multi-row cells having various heights (e.g., 3-row cells and 4-row cells) may be considered as the switch cell. The operation method and placement method of the switch cell 330 are described below with reference to FIGS. 4 and 5.

In an embodiment, the IC 300 may include a tap cell (TAP CELL). In an embodiment, tap cells 341 and 342 may be disposed based on the position of the switch cell 330. In an embodiment, the first tap cell 341 may be adjacent to the switch cell 330 in the first direction (X). For example, the first tap cell 341 may be spaced apart from the switch cell 330 by a predefined spacing in the first direction (X). In an embodiment, the first tap cell 341 may be in contact with the switch cell 330 in the first direction (X). The first tap cell 341 may be in contact with the switch cell 330 in the first direction (X).

In an embodiment, the first tap cell 341 may overlap at least a portion of the first metal line 311 or the third metal line 320. The first tap cell 341 may span the first metal line 311 and the third metal line 320. A height of the first tap cell 341 may be the same as the row R. This cell may be referred to as a single-row cell.

In an embodiment, the IC 300 may include the first tap cell 341 and the second tap cell 342 spaced apart from each other in the second direction (Y direction). The first tap cell 341 and the second tap cell 342 may be disposed in the same column (Col). However, the present disclosure is not limited thereto. The first tap cell 341 and the second tap cell 342 may be spaced apart from each other by the row R in the second direction (Y direction). In an embodiment, the second tap cell 342 may overlap the second metal line 313 overlapping the switch cell 330. The second tap cell 342 may span the second metal line 313. A height of the second tap cell 342 may be the same as the row R.

In an embodiment, the N well in the switch cell 330 may be connected to the virtual power supply voltage (VVDD) through the first tap cell 341. The P well in the switch cell 330 may be connected to the ground voltage (VSS) through the first tap cell 341. The description describes this configuration in detail below with reference to FIGS. 6 to 8.

FIG. 4 is a view for explaining a switch cell according to an embodiment.

In an embodiment, an IC 400 may include a logic circuit 430 and a switch cell 410 that provide the power supply voltage to the logic circuit 430. The switch cell 410 may include at least one transistor that is controlled by an enable signal (EN). For example, according to embodiments, the switch cell 410 may be a switch cell based on a P-type transistor or a switch cell based on an N-type transistor.

In an embodiment, the switch cell 410 may receive a power supply voltage (VDD) from the external source. The switch cell 410 may refer to an element selectively blocking a current flow through the switch cell 410 based on a control signal EN. The power supply voltage selectively output by the switch cell 410 may be referred to as the virtual power supply voltage (VVDD). The logic circuit 430 may be operated in a different mode based on the virtual power supply voltage (VVDD) selectively output by the switch cell 410. For example, in an active mode of the logic circuit 430, the switch cell 410 may supply the virtual power supply voltage (VVDD) to the logic circuit 430, and in a sleep mode of the logic circuit 430, the switch cell 410 may block the supply of the virtual power supply voltage (VVDD) to the logic circuit 430. The switch cell 410 may reduce a leakage current of the logic circuit 430 by selectively outputting the virtual power supply voltage (VVDD) based on the operation mode of the logic circuit 430.

In an embodiment, the logic circuit 430 may receive the virtual power supply voltage (VVDD) from the switch cell 410, and further receive the ground voltage (GND) from the external source. The logic circuit 430 may receive or output a logic signal based on the virtual power supply voltage (VVDD). The logic circuit 430 may include various cells for implementing the logic circuit. For example, the logic circuit 430 may include the logic cells, such as the various logic elements such as an AND gate, an OR gate, a NOR gate, an XOR gate, and an inverter, or the various memory elements such as a latch and a flipflop, or may be one of these cells.

FIG. 5 is a plan view of an IC according to an embodiment. For example, FIG. 5 is a view for explaining a floorplan method of the switch cell in an IC 500 according to an embodiment.

In an embodiment, the IC 500 may include a plurality of switch cells (SW CELL). The switch cell (SW CELL) may span the metal line that provides the virtual power supply voltage (VVDD). The switch cell (SW CELL) may provide the virtual power supply voltage (VVDD) to a plurality of logic cells through the metal line. Here, the switch cell (SW CELL) is shown as spanning two rows, but is not limited thereto.

In an embodiment, the plurality of switch cells (SW_CELL) disposed in the same row in the first direction (X direction) may be repeatedly disposed at a predetermined distance Ds. Here, the predetermined distance Ds may be a distance at which the switch cells (SW_CELL) defined in the design rule are required to be repeatedly disposed. The predetermined distance Ds may be a predetermined distance that stably provides the virtual power supply voltage (VVDD) to other logic cells in the IC 500. In an embodiment, the switch cells (SW _CELL) disposed in adjacent columns may span the plurality of rows in a staggered or alternating manner.

The placement method of the switch cells (SW_CELL) is not limited to that shown in FIG. 5. According to embodiments, the switch cells (SW _CELL) may be disposed in various forms that efficiently provide the virtual power supply voltage (VVDD) to the various cells included in the plurality of logic circuits.

FIG. 6 is a cross-sectional view of an IC. For example, FIG. 6 is a view for explaining the latch-up phenomenon that occurs in the standard cell in the IC and an operation method of the tap cell as a way to prevent or reduce this phenomenon. Here, for convenience of explanation, FIG. 6 shows only one CMOS transistor.

Referring to FIG. 6, an IC 600 may include a substrate 602. According to embodiments, the substrate 602 may be a P-type substrate or an N-type substrate. Referring to FIG. 6, the substrate 602 will be described as a P-type substrate (PSUB).

The substrate 602 may include a P well 604 and an N well 606. The P well 604 may have a dopant impurity whose type is opposite to that of the N well 606. For example, the N well 606 may include an n-type dopant impurity, and the P well 604 may include a p-type dopant impurity.

A region of the P well 604 may include a first source region S1 and a first drain region D1. The first source region S1 or the first drain region D1 may be an n-type active region(612, 614) having an n-type dopant injected in the P well 604. The first source region S1 or the first drain region D1 may extend above the substrate 602. The IC 600 may further include a first gate structure (G1) 630 disposed on the P well 604. The first gate structure 630 may be disposed between the first source region S1 and the first drain region D1. The first gate structure 630 may include a gate dielectric 622 and a gate electrode 630a. The IC 600 may further include sidewalls 620(including 620a, 620b) disposed on both sides of the first gate structure 630. The IC 600 may further include a lightly doped drain (LDD) region 618 (including 618a, 618B) adjacent to the first source region S1 and the first drain region D1 and below the sidewall 620. In an embodiment, the LDD region 618 may allow a transistor 660 to maintain a low leakage current.

The first source region S1, the first drain region D1, the LDD region 618, the sidewall 620, and the first gate structure 630 may form the transistor 660. The transistor 660 may be an N-type transistor. The first source region S1 may be connected to the ground voltage VSS through the n-type active region (614) and p-type active region(616).

A region of the N well 606 may include a second source region S2 and a second drain region D2. The second source region S2 or the second drain region D2 may be a p-type active region having a p-type dopant injected in the N well 606. The IC 600 may further include a second gate structure G2 disposed on the N well 606. The second gate structure G2 may be disposed between the second source region S2 and the second drain region D2. The second source region S2, the second drain region D2, and the second gate structure G2 may form the P-type transistor, but are not limited thereto. The second source region S2 may be connected to the power supply voltage (VDD). A description of each region formed in the region of the N well 606 is similar to the region formed in the region of the P well 604, and thus, for convenience of explanation, a further description of components and technical aspects previously described will be omitted. In addition, here, for convenience of explanation, the voltage is shown and described as the power supply voltage (VDD), and may also be the virtual power supply voltage (VVDD).

The first gate structure G1 and the second gate structure G2 of the CMOS transistor in the IC 600 may be connected to an input pin IN. The first gate structure G1 and the second gate structure G2 may receive an input signal from the external source through the input pin IN. The first drain region D1 and the second drain region D2 of the CMOS transistor in the IC 600 may be connected to an output pin OUT. The first drain region D1 and the second drain region D2 may transmit an output signal to the external source through the output pin OUT.

The IC 600 may include a first parasitic transistor (Q1) 640 and a second parasitic transistor (Q2) 650. The first parasitic transistor 640 and the second parasitic transistor 650 may be parasitic transistors formed during a CMOS transistor manufacturing process. The first parasitic transistor 640 and the second parasitic transistor 650 may be bipolar junction transistors (BJT). The latch-up phenomenon in the CMOS transistor may occur due to the first parasitic transistor 640 and the second parasitic transistor 650. Hereinafter, for convenience of explanation, these transistors are referred to as the first parasitic BJT 640 and the second parasitic BJT 650.

The first parasitic BJT 640 may be an NPN parasitic BJT formed in the N-type first source region S1, the P well 604, and the N well 606. The P well 604 may correspond to a base (B 1) 642 of the first parasitic BJT 640, the first source region S 1 may correspond to an emitter (E1) 646 of the first parasitic BJT 640, and the N well 606 may correspond to a collector (C1) 644 of the first parasitic BJT 640. A substrate resistor (Rs) 648 may correspond to resistance of the P well 604. The substrate resistor 648 may be connected between the base 642 and the emitter 646.

The second parasitic BJT 650 may be a PNP parasitic BJT formed in the P-type second source region S2, the N well 606, and the P well 604. The N well 604 may correspond to a base B2 652 of the second parasitic BJT 650, the second source region S2 may correspond to an emitter (E2) 656 of the second parasitic BJT 650, and the P well 604 may correspond to a collector (C2) 654 of the second parasitic BJT 650. A well resistor (Rw) 658 may correspond to resistance of the N well 606. The well resistor (Rw) 658 may be connected between the base 652 and the emitter 656.

The latch-up refers to a state where a low impedance path is formed between the power supply voltage (VDD) and the ground voltage (VSS). The latch-up may be caused by a latch-up trigger (current injection or overvoltage), and when the latch-up is once activated, the low impedance path may be maintained even when the trigger is no longer present. For example, the second parasitic BJT 650 may be in a forward biased state and the second parasitic BJT 650 may be turned on when a voltage level of a signal output from the output terminal OUT is higher than the power supply voltage (VDD). When the second parasitic BJT 650 is turned on, a base current Ib may flow from the collector 654 of the second parasitic BJT 650 to the base 642 of the first parasitic BJT 640. Due to this base current Ib, the first parasitic BJT 640 may be turned on, and a current may flow from a power supply voltage (VDD) terminal to a ground voltage (VSS) terminal through the two parasitic BJTs 640 and 650. A similar phenomenon may occur when the signal output from the output terminal OUT is lower than the ground voltage (VSS). Through the low impedance path formed in this way, the current may flow from the power supply voltage (VDD) terminal to the ground voltage (VSS) terminal, thereby causing fatal damage to the IC 600.

To prevent this latch-up phenomenon, the N well 606 may be connected to the power supply voltage (VDD), and the P well 604 may be connected to the ground voltage (VSS). This state may be referred to as well tapping. For example, the N well 606 may be connected to the power supply voltage (VDD) through an N-well tap B2, and the P well 604 may be connected to the ground voltage (VSS) through a P-well tap B1. Thus, according to embodiments of the present disclosure, the first parasitic BJT 642 and the second parasitic BJT 652 may be prevented from being turned on in a certain situation (for example, when the voltage level of the signal output from the output terminal OUT is higher than the power supply voltage (VDD) or lower than the ground voltage (VSS).

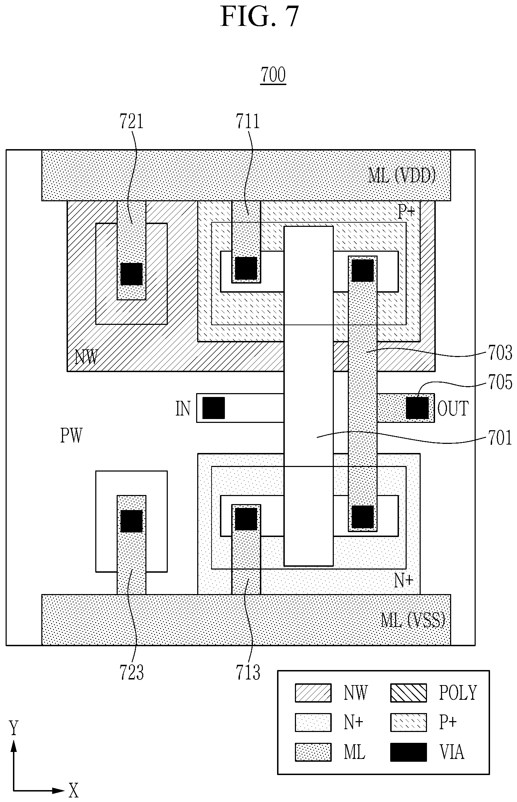

FIG. 7 is a layout plan view of the IC in FIG. 6. For example, FIG. 7 is a schematic layout plan view of the CMOS transistor in FIG. 6.

Referring to FIG. 7, an N well NW may be formed in a region adjacent to a P well PW. The N well NW may be formed in at least a portion of a CMOS transistor 700.

The CMOS transistor 700 may include the source region and the drain region as a p-type active region (p+) on the N well NW, and these regions may form the P-type transistor together with a gate terminal. In addition, the CMOS transistor 700 may include the source region and the drain region as the n-type active region (n+) on a P well PW, and these regions may form the N-type transistor together with the gate terminal.

The CMOS transistor 700 may receive the power supply voltage (VDD) and the ground voltage (VSS) from the metal line ML extending in the first direction (X direction). The CMOS transistor 700 may have a gate terminal 701 connected to the input pin IN to thus receive an input signal from the external source, and a drain terminal 703 connected to the output pin OUT to thus transmit the output signal to the external source. Each terminal may be connected to the metal line that transmits the signal through a via 705.

A source terminal 711 on the N well NW may be connected to the metal line ML that supplies the power supply voltage (VDD), and a source terminal 713 on the P well PW may be connected to the metal line ML that supplies the ground voltage (VSS). The N well NW may be connected to the metal line ML that supplies the power supply voltage (VDD) through a N-well tap 721, and the P well PW may be connected to the metal line ML that supplies the ground voltage (VSS) through a P-well tap 723.

An area occupied by the CMOS transistor 700 in the IC may be increased as the CMOS transistor 700 includes the tab regions (e.g., 721 and 723). According to embodiments, the standard cells in the IC, such as the logic cell and the switch cell, may be provided as tapless cells without the tap region, which may decrease the area occupied by the CMOS transistor 700 in the IC. A well region in the tapless cell may be connected to the power supply voltage (VDD) or the ground voltage (VSS) through the separate tap cell. The tap cell may provide well tapping to the tapless cell.

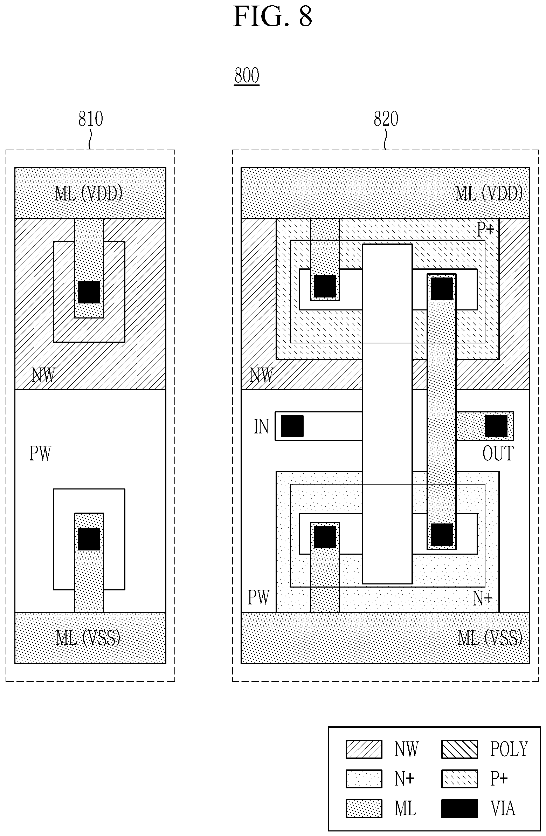

FIG. 8 is a layout plan view of the tap cell and the CMOS transistor according to an embodiment.

As described above with reference to FIG. 7, each cell may be provided as the tapless cell, which may reduce the area occupied by the standard cells such as the logic cell and the switch cell in the IC.

Referring to FIG. 8, an IC 800 according to an embodiment may include a CMOS transistor 820 and a tap cell 810. The tap cell 810 is a cell where only the tap region is separated from the CMOS transistor 700 in FIG. 7. The N well NW and the P well PW in the CMOS transistor 820 may be connected to the power supply voltage (VDD) and the ground voltage (VSS) through the tap cell 810.

The CMOS transistor is described here for convenience of explanation. However, the present disclosure is not limited thereto, and various standard cells may be provided as the tapless cells from each of which the tap region is removed.

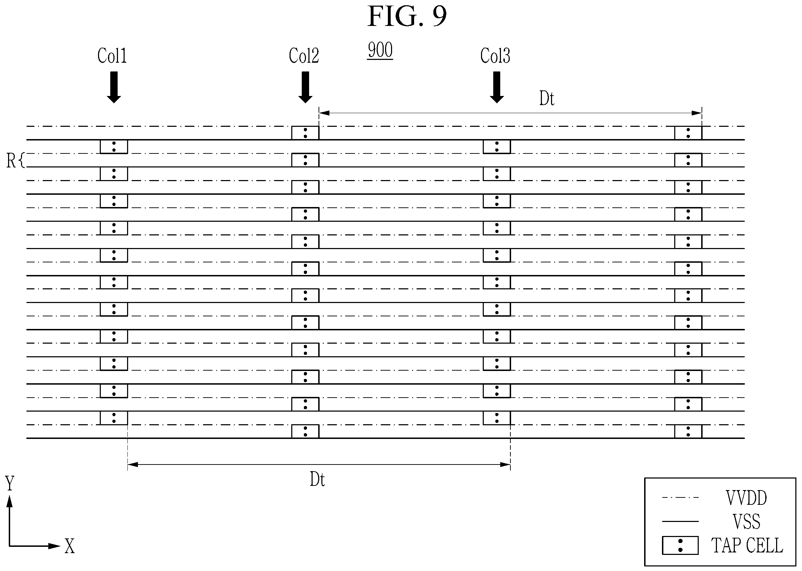

FIG. 9 is a plan view of an IC according to a comparative example. For example, FIG. 9 is a view for explaining a floorplan method of the tap cell in an IC 900 according to the comparative example.

The IC 900 according to the comparative example may include a plurality of tap cells (TAP CELL). The tap cell (TAP CELL) may span the metal line that provides the virtual power supply voltage (VVDD) and the metal line that provides the ground line (VSS). The tap cell (TAP CELL) may provide the well tapping to the logic cell and the switch cell disposed at a certain distance.

The plurality of tap cells (TAP CELL) disposed in the same row in the first direction (X direction) may be disposed repeatedly at a predetermined distance Dt. Here, the predetermined distance Dt may be a distance at which the tap cells (TAP CELL) defined in the design rule are required to be repeatedly disposed. The predetermined distance Dt may be a predetermined distance enabling the tap cell (TAP CELL) to stably provide the well tapping to the logic cell and the switch cell.

According to the comparative example, the IC 900 may include the plurality of tap cells (TAP CELL) arranged in a plurality of columns Col1, Col2, and Col3 spaced at a certain spacing in the first direction (X). The tap cells (TAP CELL) disposed in each column Col1, Col2, or Col3 may be disposed while having the certain spacing in the second direction (Y). Here, the spacing at which the tap cells (TAP CELL) disposed in each column Col1, Col2, or Col3 are spaced apart from each other may be the row R.

According to the comparative example, the tap cell (TAP CELL) may be spaced apart by the same distance in the first direction (X) from the tap cell (TAP CELL) disposed in an adjacent row. For example, the second column Col2 may be adjacent to the first column Col1 and the third column Col3 in the first direction (X), and the tap cells disposed in the second column Col2 may be spaced apart by the same distance in the first direction (X) from the tap cells disposed in the first column Col1 and the third column Col3. According to the comparative example, the tap cells (TAP CELL) disposed in the adjacent rows may be disposed in the staggered or alternating manner.

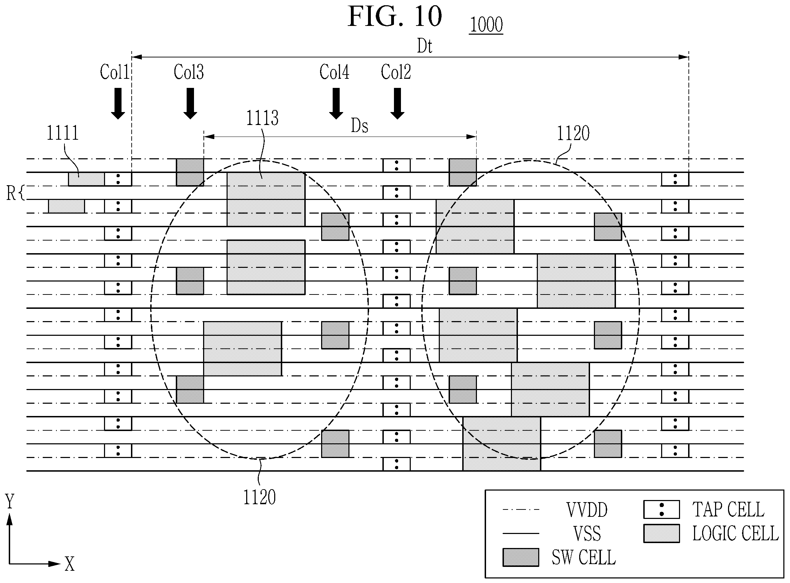

Herein, a placement method of the switch cell and the tap cell according to the comparative example with reference to FIG. 10 will be described.

FIG. 10 is a layout diagram showing a floorplan of the switch cell and the tap cell according to the comparative example. For example, FIG. 10 is a view for explaining problems that may be caused by disposing the switch cell and the tap cell according to the comparative example.

Referring to FIG. 10, an IC 1000 according to the comparative example may include the plurality of tap cells (TAP CELL) arranged in the first column Col1 and the second column Col2. The tap cells arranged in the first column Col1 and the tap cells arranged in the second column Col2 may be tap cells adjacent in the first direction (X). The IC 1000 according to the comparative example may include the plurality of switch cells (SW CELL) arranged in the third column Col3 and a fourth column Col4. The tap cells arranged in the first column Col1 and the switch cells arranged in the third column Col3 may be the adjacent cells in the first direction (X). In addition, the tap cells arranged in the second column Col2 and the switch cells arranged in the fourth column Col4 may be the adjacent cells in the first direction (X).

The switch cell (SW CELL) and the tap cell (TAP CELL) may be disposed, and the logic cells may be disposed in the remaining space. The logic cells may include a first logic cell as the single-row cell occupying one row R and a second logic cell as a multi-row cell occupying a plurality of rows (e.g., 4R). Among the logic cells, the multi-row cell may include, for example, a multi-bit flip flop, a level shifter, or the like, but is not limited thereto.

A region capable of disposing the multi-row cell may be limited depending on a placement form of the switch cell and tap cell according to the comparative example. For example, due to a space constraint, the multi-row cell is unable to be disposed in a region between the tap cell (TAP CELL) and the switch cell (SW_CELL) adjacent to each other in the first direction (X). For example, the multi-row cell is unable to disposed between the tap cell (TAP CELL) of the first column Coll and the switch cell (SW CELL) of the third column Col3 or between the tap cell (TAP CELL) of the second column Col2 and the switch cell (SW CELL) of the fourth column Col4, which are adjacent to each other in the first direction (X). Alternatively, the multi-row cell may be disposed only between the switch cell (SW CELL) of the third column Col3 and the switch cell (SW CELL) of the fourth column Col4. These regions may be the regions where the tap cells are not disposed. Accordingly, the multi-row cells are required to be disposed densely in a specific region 1120. The multi-row cell may include the plurality of input pins and/or the plurality of output pins, and the multi-row cell may thus be connected to a larger number of the routing structures than the number of single-row cells. Therefore, routing congestion may occur in the region 1120 where the multi-row cells are densely disposed.

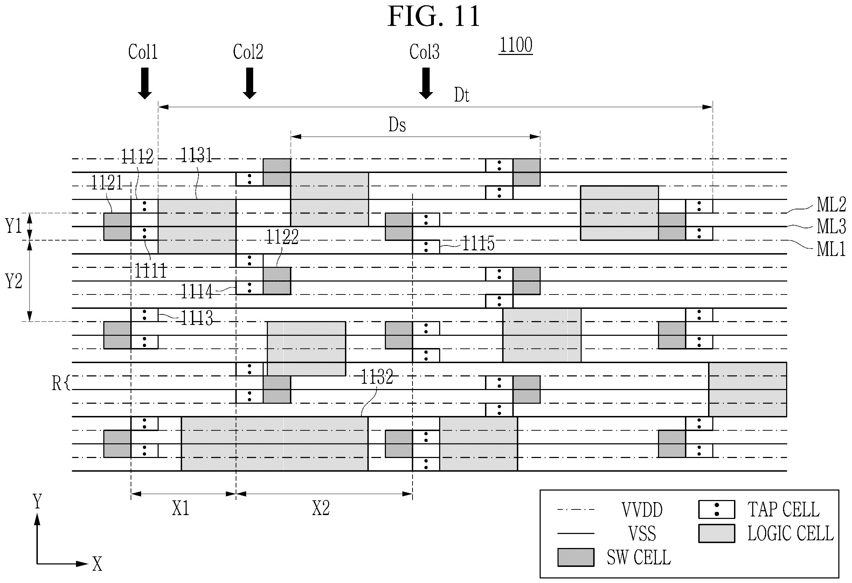

FIG. 11 is a plan view of an IC according to an embodiment.

In an embodiment, an IC 1100 includes the plurality of tap cells (TAP CELL) that are repeatedly disposed in the same row at the predetermined distance Dt in the first direction (X). In addition, the IC 1100 may include the plurality of switch cells (SW CELL) that are disposed repeatedly in the same row at the predetermined distance Ds in the first direction (X). The IC 1100 may include a plurality of logic cells (LOGIC CELL). Here, for convenience of explanation, only the logic cell (LOGIC CELL) provided as the multi-row cell is shown. However, the present disclosure is not limited thereto.

In an embodiment, the IC 1100 may include the first (TAP CELL) 1111 adjacent to a switch cell 1121 in the first direction (X). In an embodiment, the IC 1100 may include the first (TAP CELL) 1111 in contact with the switch cell 1121 in the first direction (X direction). The first switch cell 1121 according to an embodiment may be the tapless cell, and the first (TAP CELL) 1111 may provide the well tapping to the first switch cell 1121. The IC 1100 may further include a second tap cell 1112 disposed in the first column Col1 where the first tap cell 1111 is disposed, and spaced apart from the first tap cell 1111 by the row R. The switch cell 1121 may provide the virtual power supply voltage (VVDD) through the plurality of metal lines. The first tap cell 1111 may be connected to a first metal line ML1 among the plurality of metal lines through which the switch cell 1121 provides the virtual power supply voltage (VVDD), and the second tap cell 1112 may be connected to a second metal line ML2 among the plurality of metal lines through which the switch cell 1121 provides the virtual power supply voltage (VVDD). The first metal line ML1 and the second metal line MI,2 may extend in the first direction (X), and a third metal line ML3, which extends in the first direction (X) and provides the ground voltage (VSS), may be disposed between the first metal line ML1 and the second metal line ML2.

In an embodiment, the IC 1100 may include the plurality of tap cells (TAP CELL) arranged in the plurality of columns Col1, Col2, and Col3. Although not explicitly labeled in FIG. 11, as shown, embodiments further include additional columns. In the first column Col1, the second tap cell 1112 (also referred to as a 1-2 tap cell), the first tap cell 1111 (also referred to as a 1-1 tap cell), and a third tap cell 1113 (also referred to as a 1-3 tap cell) may be arranged sequentially in the second direction (Y). In the first column Col1, the first tap cell 1111 may be adjacent to the second tap cell 1112 and the third tap cell 1113 in the second direction (Y). Here, a first distance Y1 between the first tap cell 1111 and the second tap cell 1112 may be different from a second distance Y2 between the first tap cell 1111 and the third tap cell 1113.

In an embodiment, the plurality of columns Col1, Col2, and Col3 of the IC 1100 may be disposed sequentially in the first direction (X), and the second column Col2, at which the plurality of tap cells (TAP CELL) are arranged, may be adjacent to the first column Col1 and the third column Col3 in the first direction (X). For example, the second column Col2 may be disposed between the first column Col1 and the third column Col3. The tap cells disposed in the second column Col2 may be adjacent to the tap cells disposed in the first column Col1 and the tap cells disposed in the third column Col3, in the first direction (X). For example, a fourth tap cell 1114 disposed in the second column Col2 may be adjacent to the first tap cell 1111 disposed in the first column Col1 and a fifth tap cell 1115 disposed in the third column Col3, in the first direction (X). Here, a third distance X1 between the second column Col2 and the first column Col1 may be different from a fourth distance X2 between the second column Col2 and the third column Col3. That is, a distance between the fourth tap cell 1114 and the first tap cell 1111 in the first direction (X) may be different from a distance between the fourth tap cell 1114 and the fifth tap cell 1115 in the first direction (X). The tap cells disposed in the adjacent columns in the first direction (X) may be disposed in different rows. The plurality of tap cells disposed in the first column Col1, the plurality of tap cells disposed in the second column Co 12, and the plurality of tap cells disposed in the third column Col3 may be disposed in the different rows. For example, the first tap cell 1111, the fourth tap cell 1114, and the fifth tap cell 1115 may be disposed in the different rows.

In an embodiment, a direction in which the tap cells arranged in the adjacent columns in the first direction (X) are in contact with the switch cells may be opposite directions. For example, the first column Col1 and the second column Col2 may be the adjacent columns in the first direction (X). The first tap cells 1111 arranged in the first column Col1 may be in contact with the first switch cell 1121 in a direction opposite to the first direction (X) (e.g., a leftward direction in FIG. 11), and the fourth tap cells 1114 arranged in the second column Col2 may be in contact with a second switch cell 1122 in the first direction (X) (e.g., a rightward direction in FIG. 11).

In an embodiment, the IC 1100 may include the multi-row cell disposed between the adjacent tap cells in the first direction (X). For example, the IC 1100 may include a multi-row cell 1131 disposed between the tap cells disposed in the first column Col1 and the second column Col2, adj acent to each other in the first direction (X). Here, according to embodiments, the switch cell (SW CELL) is not disposed between the first column Col1 and the second column Col2.

Accordingly, embodiments of the present disclosure may secure more space for disposing the multi-row cell in the IC by disposing the tap cell. For example, according to an embodiment, the routing congestion of the IC may be improved by disposing the tap cell. For example, according to an embodiment, the IC 1100 may include multi-row cells of various sizes (e.g., 1132) in the first direction (X) by disposing the tap cell.

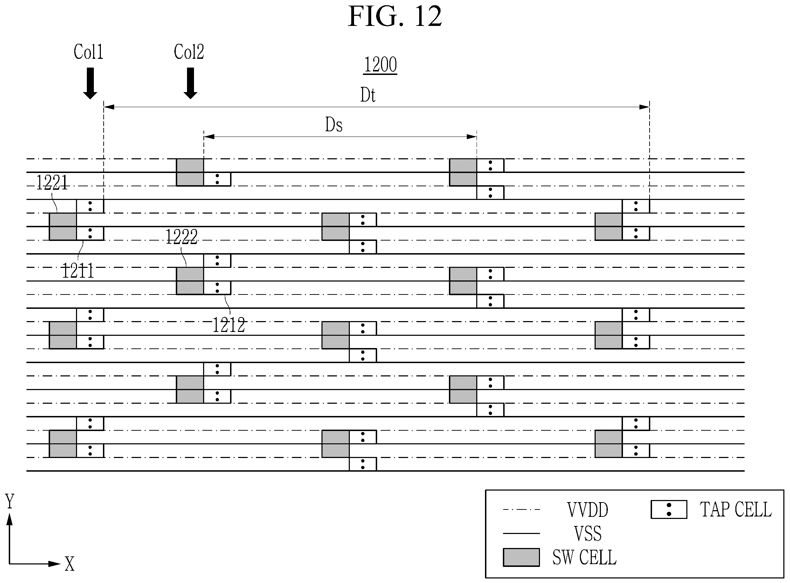

FIG. 12 is a plan view of an IC according to an embodiment. For convenience of explanation, a further description of components and technical aspects previously described with reference to FIG. 11 will be omitted.

In an embodiment, an IC 1200 may include the plurality of tap cells (TAP CELL) that are repeatedly disposed in the same row at the predetermined distance Dt in the first direction (X). In addition, the IC 1200 may include the plurality of switch cells (SW CELL) that are disposed repeatedly in the same row at the predetermined distance Ds in the first direction (X).

In an embodiment, the IC 1200 may include the plurality of tap cells (TAP CELL) arranged in the plurality of columns Col1 and Col2. The plurality of columns Col1 and Col2 may be adjacent to each other in the first direction (X). In an embodiment, the tap cells (TAP CELL) arranged in the plurality of columns of the IC 1200 may be in contact with the switch cell (SW CELL) in the same direction. For example, first tap cells 1211 arranged in the first column Col1 may be in contact with a first switch cell 1221 in the first direction (X), and second tap cells 1212 arranged in the second column Col2 may also be in contact with a second switch cell 1222 in the first direction (X). The tap cells disposed in the adjacent columns Col1 and Col2 may be disposed in the different rows.

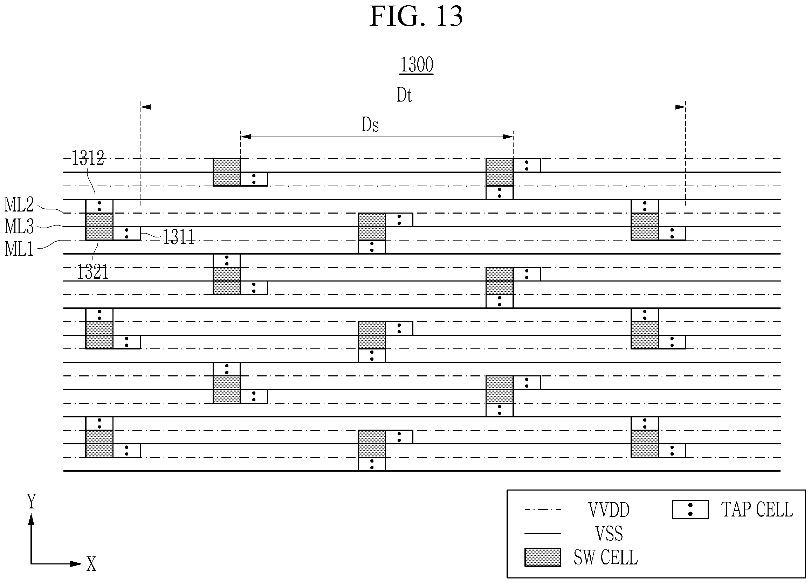

FIG. 13 is a plan view of the IC according to an embodiment. For convenience of explanation, a further description of components and technical aspects previously described with reference to FIG. 12 will be omitted.

In an embodiment, an IC 1300 includes the plurality of tap cells (TAP CELL) that are repeatedly disposed in the same row at the predetermined distance Dt in the first direction (X). In addition, the IC 1300 includes the plurality of switch cells (SW CELL) that are disposed repeatedly in the same row at the predetermined distance Ds in the first direction (X).

In an embodiment, the IC 1300 may include a first (TAP CELL) 1311 adjacent to a switch cell 1321 in the first direction (X). In an embodiment, the IC 1300 may include the first (TAP CELL) 1311 in contact with the switch cell 1321 in the first direction (X). The first tap cell 1311 may provide the well tapping to the first switch cell 1321. In an embodiment, the IC 1300 may further include a second tap cell 1312 adjacent to the first switch cell 1321 in the second direction (Y).

The switch cell 1321 may provide the virtual power supply voltage (VVDD) through the plurality of metal lines. The first tap cell 1311 may be connected to the first metal line ML1 among the plurality of metal lines through which the switch cell 1321 provides the virtual power supply voltage (VVDD), and the second tap cell 1312 may be connected to the second metal line ML2 among the plurality of metal lines through which the switch cell 1321 provides the virtual power supply voltage (VVDD). The first metal line ML1 and the second metal line ML2 may extend in the first direction (X), and the third metal line ML3, which extends in the first direction (X) and provides the ground voltage (VSS), may be disposed between the first metal line ML1 and the second metal line ML2.

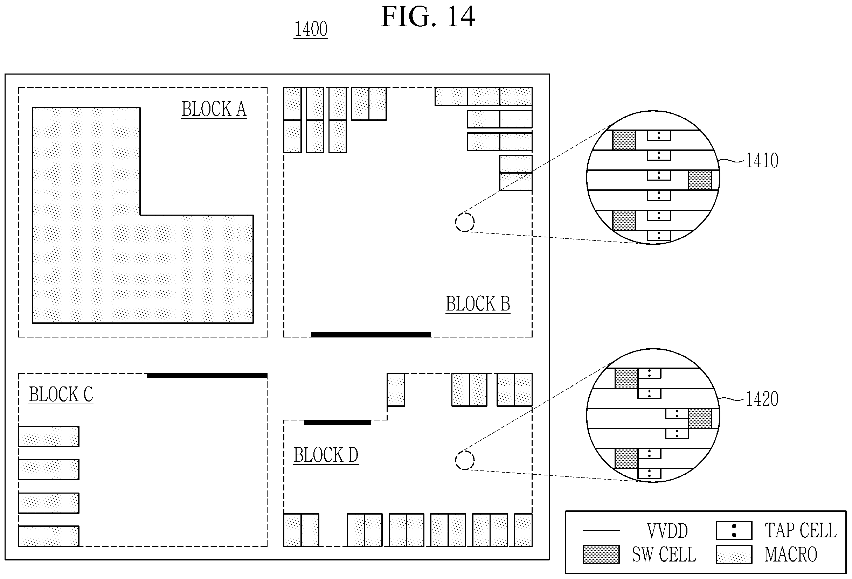

FIG. 14 is a plan view of an IC according to an embodiment. An IC 1400 according to an embodiment may be a system-on-chip (SOC).

In an embodiment, the IC 1400 may include a plurality of blocks (BLOCK A, BLOCK B, BLOCK C, and BLOCK D). The plurality of blocks (BLOCK A, BLOCK B, BLOCK C, and BLOCK D) may be classified based on their functions. Each of the plurality of blocks (BLOCK A, BLOCK B, BLOCK C, and BLOCK D) may include different or the same number and type of the standard cells and macros (MACRO).

In an embodiment, the IC 1400 may be one in which the floorplan operation (S 110) according to FIG. 1 is performed. For example, the IC 1400 may be one in which the floorplan is performed for the switch cell (SW CELL) and the tap cell (TAP CELL). In an embodiment, the tap cells disposed in the first block (BLOCK B) and the second block (BLOCK D) of the IC 1400 may be disposed in different shapes. For example, the IC 1400 may include the first block (BLOCK B) having a tap cell 1410 disposed according to the comparative example, and the second block (BLOCK D) having a tap cell 1420 disposed according to an embodiment of the present disclosure. The tap cells of the second block (BLOCK D) may be disposed according to at least one of FIGS. 11 to 13.

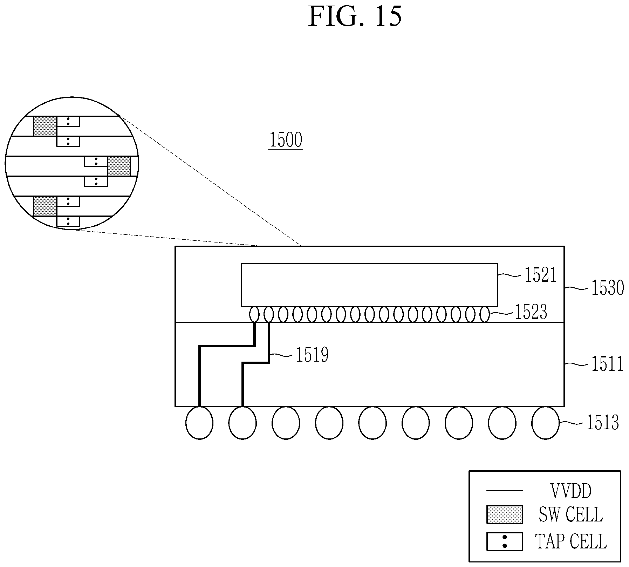

FIG. 15 is a cross-sectional view schematically showing a semiconductor package including a semiconductor device based on the IC provided according to an embodiment.

A semiconductor device 1521 may be manufactured based on the layout designed according to an embodiment. A semiconductor package 1500 may be manufactured by performing a packaging process that flips or bonds the semiconductor device 1521 manufactured by a manufacturing module onto a substrate 1511.

The semiconductor package 1500 may include the semiconductor device 1521, the substrate 1511, connection members 1523 connected between the semiconductor device 1521 and the substrate 1511, external source connection members 1513 connected to the substrate 1511, and a molding material 1530. FIG. 15 shows that the semiconductor device 1521 is mounted using a flip-chip bonding method. However, the mounting method is not limited thereto. In addition, FIG. 15 shows that one semiconductor devices 1521 is mounted on the substrate 1511. However, the number of semiconductor devices is not limited thereto. For example, in an embodiment, a semiconductor die stack including the plurality of semiconductor devices may be mounted on the substrate 1511, and the semiconductor package 1500 may further include a redistribution structure between the semiconductor device 1521 and the substrate 1511.

The semiconductor device 1521 according to an embodiment may include blocks that perform various functions. At least some of the blocks in the semiconductor device 1521 may include the switch cell that power gates and the tap cells that provides the well tapping. The tap cells in the semiconductor device 1521 according to an embodiment may be disposed according to at least one of FIGS. 11 to 13.

The semiconductor device 1521 and a wiring 1519 formed on the substrate 1511 may be electrically connected to each other through the connection members 1523 bonded on the substrate 1511. In an embodiment, the semiconductor device 1521 may receive the power supply voltage (VDD) and the ground voltage (VSS) from the external source through the connection members 1523, the wiring 1519, and the external source connection members 1513. In an embodiment, the connection member 1523 may transmit the power supply voltage (VDD) and the ground voltage (VSS) to the semiconductor device 1521. The connection member 1523 may include a micro bump.

The molding material 1530 may mold the semiconductor device 1521, which may protect the semiconductor device 1521 from the external environment, and secure the electrical and mechanical stability of the semiconductor package 1500.

As is traditional in the field of the present disclosure, embodiments are described, and illustrated in the drawings, in terms of functional blocks, units and/or modules. Those skilled in the art will appreciate that these blocks, units and/or modules are physically implemented by electronic (or optical) circuits such as logic circuits, discrete components, microprocessors, hard-wired circuits, memory elements, wiring connections, etc., which may be formed using semiconductor-based fabrication techniques or other manufacturing technologies. In the case of the blocks, units and/or modules being implemented by microprocessors or similar, they may be programmed using software (e.g., microcode) to perform various functions discussed herein and may optionally be driven by firmware and/or software. Alternatively, each block, unit and/or module may be implemented by dedicated hardware, or as a combination of dedicated hardware to perform some functions and a processor (e.g., one or more programmed microprocessors and associated circuitry) to perform other functions.

While the present disclosure has been particularly shown and described with reference to embodiments thereof, it will be understood by those of ordinary skill in the art that various changes in form and detail may be made therein without departing from the scope of the present disclosure as defined by the following claims.
Embodiments are set out in the following clauses:
Clause 1. An integrated circuit (IC), comprising: a first line extending in a first direction and configured to provide a power supply voltage; a second line extending in the first direction and configured to provide the power supply voltage; a third line extending in the first direction between the first line and the second line and configured to provide a ground voltage; a first switch cell overlapping the first line, the second line, and the third line, and spanning the first line and the second line; a first tap cell in contact with the first switch cell in the first direction, and spanning the first line and the third line; and a second tap cell spaced apart from the first tap cell by a first distance in a second direction perpendicular to the first direction, and spanning the second line.
Clause 2. The IC of clause 1, further comprising: a third tap cell disposed in a same column as the first tap cell, and spaced apart from the second tap cell by a second distance, which is different from the first distance, in the second direction.
Clause 3. The IC of clause 1 or 2, wherein the second tap cell is in contact with the first switch cell in the second direction.
Clause 4. An integrated circuit (IC), comprising: a first switch cell disposed in a first column among the first column, a second column, a third column, and a fourth column sequentially arranged and adjacent to one another in a first direction; a first tap cell disposed in the second column and in contact with the first switch cell in the first direction; a second tap cell disposed in the third column spaced apart by a first distance from the second column; and a second switch cell disposed in the fourth column and in contact with the second tap cell in the first direction.
Clause 5. The IC of clause 4, further comprising a first logic cell, which is a multi-row cell disposed between the first tap cell and the second tap cell.
Clause 6 The IC of claim 5, further comprising: a third tap cell disposed in the second column, and spaced apart from the first tap cell by a second distance in a second direction perpendicular to the first direction; and a fourth tap cell disposed in the second column, and spaced apart from the first tap cell by a third distance, which is different from the second distance in a direction opposite to the second direction.
Clause 7. The IC of claim 4, 5 or 6, further comprising: a third tap cell disposed in a fifth column spaced apart from the third column by a second distance different from the first distance in the first direction.
Clause 8. The IC of any one of clauses 4 to 6, wherein
   the first tap cell provides well tapping to the first switch cell, and the second tap cell provides the well tapping to the second switch cell.

## Claims

1. An integrated circuit, IC, comprising:
a plurality of first tap cells arranged in a first column;
a plurality of second tap cells arranged in a second column and disposed in a row that is different from a row in which the plurality of first tap cells are disposed,
wherein the second column is adjacent to the first column in a first direction and spaced apart from the first column by a first distance; and
a plurality of third tap cells arranged in a third column and disposed in a row different from the row in which the plurality of first tap cells are disposed and different from the row in which the plurality of second tap cells are disposed,
wherein the third column is adjacent to the first column in the first direction and spaced apart from the first column by a second distance that is different from the first distance.

2. The IC of claim 1, wherein
the plurality of first tap cells include a 1-1 tap cell, a 1-2 tap cell, and a 1-3 tap cell,
the 1-2 tap cell, the 1-1 tap cell and the 1-3 tap cell are sequentially arranged adjacent to one another in a second direction perpendicular to the first direction, and
the 1-1 tap cell and the 1-2 tap cell are spaced apart from each other by a third distance in the second direction, and the 1-1 tap cell and the 1-3 tap cell are spaced apart from each other by a fourth distance, which is different from the third distance, in the second direction.

3. The IC of claim 2, further comprising:
a first switch cell in contact with the 1-1 tap cell in the first direction.

4. The IC of claim 3, further comprising:
a first metal line extending in the first direction, overlapping the first switch cell, and configured to provide a power supply voltage;
a second metal line extending in the first direction, overlapping the first switch cell, configured to provide the power supply voltage, and spaced apart from the first metal line in the second direction; and
a third metal line extending in the first direction between the first metal line and the second metal line and configured to provide a ground voltage,
wherein the 1-1 tap cell spans the first metal line and the third metal line.

5. The IC of claim 4, wherein
the 1-2 tap cell spans the second metal line, and
the third distance is about equal to a distance between the second metal line and the third metal line.

6. The IC of claim 3, 4 or 5, further comprising:
a second switch cell in contact with one of the plurality of third tap cells in a direction opposite to the first direction.

7. The IC of claim 6, further comprising:
a first logic cell, which is a multi-row cell disposed between the plurality of first tap cells and the plurality of third tap cells.

8. The IC of any one of claims 1 to 7 comprising:
a first line extending in a first direction and configured to provide a power supply voltage;
a second line extending in the first direction and configured to provide the power supply voltage;
a third line extending in the first direction between the first line and the second line and configured to provide a ground voltage;
a first switch cell overlapping the first line, the second line, and the third line, and spanning the first line and the second line;
a first tap cell in contact with the first switch cell in the first direction, and spanning the first line and the third line; and
a second tap cell spaced apart from the first tap cell by a first distance in a second direction perpendicular to the first direction, and spanning the second line.

9. The IC of claim 8, further comprising:
a third tap cell disposed in a same column as the first tap cell, and spaced apart from the second tap cell by a second distance, which is different from the first distance, in the second direction.

10. The IC of claim 8 or 9, wherein
the second tap cell is in contact with the first switch cell in the second direction.

11. The IC of any one of claims 1 to 10, comprising:
a first switch cell in contact with a 1-1 tap cell among the plurality of first tap cells in the first direction; and
a second switch cell in contact with a 2-1 tap cell amoung the plurality of second tap cells in the first direction.

12. The IC of claim 11, further comprising:
a first logic cell, which is a multi-row cell disposed between the 1-1 tap cell and the 2-1 tap cell.

13. The IC of claim 12, the plurality of first tap cells comprising:
a 1-2 tap cell spaced apart from the 1-1 tap cell by a third distance in a second direction perpendicular to the first direction; and
a 1-3 tap cell spaced apart from the 1-1 tap cell by a forth distance, which is different from the third distance in a direction opposite to the second direction.

14. The IC of claim 11, 12 or 13, wherien the first switch cell is disposed in a row different from a row in which the second switch cell is disposed.

15. The IC of any one of claims 11 to 14, wherein
the 1-1 tap cell provides well tapping to the first switch cell, and the 2-1 tap cell provides the well tapping to the second switch cell.
